# EUROPÄISCHE PATENTSCHRIFT

(11) **EP 4 423 812 B1**
(45) Veröffentlichungstag und Bekanntmachung des Hinweises auf die Patenterteilung: **23.09.2026**
(21) Anmeldenummer: 22802893.2
(22) Anmeldetag: 25.10.2022
(51) Int. Cl.: H10F 19/35, H10F 77/20, H10K 30/83, H10K 30/88, H10K 39/00

(54) **ELEKTRISCHES BAUELEMENT MIT EINER ELEKTRISCH LEITFÄHIGEN BESCHICHTUNG ZUR KONTAKTIERUNG EINER AUSSERHALB DER BESCHICHTUNG ANGEORDNETEN SAMMELSCHIENE**
ELECTRICAL COMPONENT WITH AN ELECTRICALLY CONDUCTIVE COATING FOR CONTACTING A BUS BAR LOCATED OUTSIDE THE COATING
COMPOSANT ÉLECTRIQUE AVEC UN REVÊTEMENT ÉLECTROCONDUCTEUR DESTINÉ À CONTACTER UNE BARRE OMNIBUS SITUÉE HORS DU REVÊTEMENT

(30) Priorität: 25.10.2021 DE 102021127720
(43) Veröffentlichungstag der Anmeldung: 04.09.2024
(73) Patentinhaber: Heliatek GmbH, 01139 Dresden (DE)
(72) Erfinder: FISCHER, Dustin, 01139 Dresden (DE)
(86) Internationale Anmeldenummer: PCT/DE2022/100789
(87) Internationale Veröffentlichungsnummer: WO 2023/072340

(56) Entgegenhaltungen:
- US-A1- 2021 028 322
- WANG HEMING ET AL: "Transparent and conductive polysiloxanes/PEDOT:PSS nanocomposite thin films with a "water-impermeable" property to significantly enhance stability of organic-inorganic hybrid solar cells", RSC ADVANCES, vol. 5, no. 13, 1 January 2015 (2015-01-01), pages 9650 - 9657, XP093014293, Retrieved from the Internet <URL:https://pubs.rsc.org/en/content/articlepdf/2015/ra/c4ra14079f> DOI: 10.1039/C4RA14079F
- ZHANG YUNFANG ET AL: "Heterojunction with Organic Thin Layers on Silicon for Record Efficiency Hybrid Solar Cells", ADVANCED ENERGY MATERIALS, vol. 4, no. 2, 16 September 2013 (2013-09-16), DE, pages 1300923, XP055880143, ISSN: 1614-6832, DOI: 10.1002/aenm.201300923

## Beschreibung

Die Erfindung betrifft ein elektrisches Bauelement mit einer elektrisch leitfähigen Beschichtung, und ein Verfahren zum Beschichten eines elektrischen Bauelements mit einer solchen elektrisch leitfähigen Beschichtung. Das elektrische Bauelement ist insbesondere ein photovoltaisches Element, beispielsweise ein CIS-, CIGS-, GaAs-, oder Si-Element, ein Perovskit-Element, oder ein organisches photovoltaisches Element. Organische photovoltaische Elemente, umfassen ein Schichtsystem aus einer Folge dünner Schichten mit einer Frontelektrode, einer Rückelektrode und mit mindestens einer organischen photoaktiven Schicht zwischen der Frontelektrode und der Rückelektrode, welche bevorzugt im Vakuum aufgedampft oder aus einer Lösung prozessiert werden. Der prinzipielle Aufbau organischer photoaktiver Bauelemente ist beispielsweise in WO 2004 083 958 oder WO 2011 138 021 beschrieben, wobei die organische photoaktive Schicht Polymere oder kleine Moleküle aufweisen kann. Während sich Polymere dadurch auszeichnen, dass diese nicht verdampfbar und daher nur aus Lösungen aufgebracht werden können, sind kleine Moleküle meist verdampfbar und können entweder aus Lösung oder durch Verdampfen im Vakuum aufgebracht werden. Die elektrische Anbindung kann durch Metallschichten, transparente leitfähige Oxide und/oder transparente leitfähige Polymere erfolgen. ZHANG YUNFANG ET AL offenbart ein elektrisches Bauelement mit einer elektrisch leitfähigen Beschichtung: "Heterojunction with Organic Thin Layers on Silicon for Record Efficiency Hybrid Solar Cells",ADVANCED ENERGY MATERIALS, Bd. 4, Nr. 2, 16. September 2013 (2013-09-16), Seite 1300923.

Organische photovoltaische Elemente, zeigen eine stark verminderte Lebensdauer nach direktem Kontakt mit Luft, insbesondere Sauerstoff, und/oder Feuchtigkeit, insbesondere Wasser. Das Schichtsystem muss deshalb vor Luft und Feuchtigkeit geschützt werden, da sonst die organische Schicht beschädigt werden kann. Zum Schutz des elektrischen Bauelements wird daher eine Schutzschicht benötigt.

Aus dem Stand der Technik sind Schutzschichten zur Herstellung organischer elektrischer Bauelemente bekannt. DE102015116418A1 offenbart eine Schutzschicht und ein Verfahren zum Aufbringen der Schutzschicht im Rahmen eines kontinuierlichen Rolle-zu-Rolle-Verfahrens zur Herstellung eines Halbfabrikats organischer elektrischer Bauelemente, umfassend einen Schichtstapel auf einer Substratfolie, wobei die Schutzschicht den Schichtstapel vor und während der Endfertigung vor Umwelteinflüssen und durch Handhabung bedingte Beschädigung schützt.

Nachteilig aus dem Stand der Technik ist jedoch, dass bei einem mit einer Schutzschicht versehenen oder verkapselten elektrischen Bauelement, insbesondere einem photovoltaischen Element, die Schutzschicht zum Herausführen oder zum Hineinführen des elektrischen Stroms aus dem elektrischen Bauelement, von einer Elektrode zu einer außerhalb der Schutzschicht oder der Verkapselung angeordneten Sammelschiene, geöffnet werden muss. Durch eine solche Öffnung kann Luftsauerstoff oder Feuchtigkeit in das Innere des elektrischen Bauelements eindringen.

Der Erfindung liegt daher die Aufgabe zugrunde, ein elektrisches Bauelement gemäß den Ansprüchen mit einer elektrisch leitfähigen Beschichtung bereitzustellen, wobei die genannten Nachteile nicht auftreten, welche insbesondere eine Schutzschicht auf einem Schichtsystem eines elektrischen Bauelements bildet und welche zur Kontaktierung von Elektroden des Schichtsystems mit einem außerhalb der Beschichtung liegenden Sammelschiene nicht geöffnet werden muss, wodurch Luft und/oder Feuchtigkeit in das Schichtsystem eindringen kann.

Die Aufgabe wird durch die Gegenstände der unabhängigen Ansprüche gelöst. Vorteilhafte Ausgestaltungen ergeben sich aus den Unteransprüchen.

Die Aufgabe wird insbesondere gelöst, indem eine elektrisch leitfähige Beschichtung eines elektrischen Bauelements gemäß den Ansprüchen 2 zur elektrisch leitfähigen Kontaktierung einer außerhalb der Beschichtung angeordneten ersten Sammelschiene bereitgestellt wird, das elektrische Bauelement aufweisend mindestens eine Zelle mit mindestens einem strukturierten Schichtsystem, wobei das mindestens eine Schichtsystem eine Frontelektrode, eine Rückelektrode, und mindestens eine photoaktive Schicht aufweist, und die mindestens eine photoaktive Schicht zwischen der Frontelektrode und der Rückelektrode angeordnet ist, wobei das mindestens eine Schichtsystem derart strukturiert ist, dass die Rückelektrode durch mindestens einen Graben unterbrochen ist, und zumindest die Rückelektrode der mindestens einen Zelle mit der Beschichtung beschichtet und der mindestens eine Graben der Rückelektrode mit der Beschichtung gefüllt ist. Die Beschichtung weist dabei einen spezifischen Widerstand von 0,01 bis 10000 Ωm auf, wobei ein Verhältnis des elektrischen Widerstands zwischen der Rückelektrode und der ersten Sammelschiene der Beschichtung (R_{Schicht}) und dem elektrischen Widerstand über der Breite des Grabens mit der Beschichtung (R_{Graben}) mindestens 1:1000 beträgt.

Erfindungsgemäß ist der elektrische Widerstand über die Breite des die Rückelektrode unterbrechenden mindestens einen Grabens mit der Beschichtung (R_{Graben}) größer als der elektrische Widerstand der Beschichtung zwischen der Rückelektrode und der ersten Sammelschiene (R_{Schicht}). Erfindungsgemäß fließt der elektrische Strom nicht durch den mit der Beschichtung gefüllten Graben, da der elektrische Widerstand, insbesondere der sich aus den geometrischen Abmessungen ergebende elektrische Widerstand, über die Breite des Grabens zu groß ist. Dadurch wird ein elektrischer Stromfluss zwischen der Rückelektrode und der Sammelschiene begünstigt. Die Erfindung betrifft bevorzugt eine Schutzschicht, insbesondere einen Wickelschutz, zum Schutz des elektrischen Bauelements und zur elektrisch leitfähigen Kontaktierung einer außerhalb der Beschichtung angeordneten Sammelschiene.

Unter einer Beschichtung wird insbesondere eine Schicht verstanden, die einen Schutz, insbesondere eine Barriere, gegenüber chemischen Verbindungen, Verunreinigungen, Feuchtigkeit und/oder Sauerstoff, insbesondere Luftsauerstoff, bildet. Unter einer Schutzschicht wird insbesondere auch eine Schicht zur Erhöhung der mechanischen Widerstandsfähigkeit, insbesondere Kratzfestigkeit, und/oder eine Filterschicht, bevorzugt eine Schicht mit einem UV-Filter, verstanden.

Unter einem elektrischen Bauelement wird insbesondere ein photovoltaisches Element verstanden. Das photovoltaische Element ist bevorzugt aus mehreren Zellen aufgebaut, die in Reihe oder parallel verschaltet sein können. Die mehreren Zellen können auf unterschiedliche Weise in dem elektrischen Bauelement angeordnet und/oder verschaltet sein. Bei dem elektrischen Bauelement kann es sich um ein Halbfabrikat oder ein Endfabrikat handeln. In einer bevorzugten Ausführungsform wird unter einem elektrischen Bauelement ein Halbfabrikat eines elektrischen Bauelements verstanden.

Unter einer Vorderseite eines elektrischen Bauelements, insbesondere eines photovoltaischen Elements, wird eine bestimmungsgemäß einem Sonnenlicht zugewandte Seite des elektrischen Bauelements verstanden. Dementsprechend wird unter einer Rückseite eines elektrischen Bauelements, insbesondere eines photovoltaischen Elements, eine bestimmungsgemäß einem Sonnenlicht abgewandte Seite des elektrischen Bauelements verstanden.

Unter einer Sammelschiene, einem sogenannten Busbar, wird insbesondere eine Anordnung verstanden, die zur elektrischen Kontaktierung als zentraler Verteiler von elektrischer Energie an ankommende und abgehende Leitungen elektrisch leitend verbunden ist, bevorzugt mit mindestens einer Frontelektrode und/oder mindestens einer Rückelektrode des photovoltaischen Elements. Die Sammelschiene ist insbesondere planar als Band, Streifen, oder Platte ausgebildet.

Unter einer außerhalb der Beschichtung angeordneten Sammelschiene wird insbesondere eine auf der Beschichtung auf einer dem Schichtsystem entgegengesetzten Seite des Schichtsystems angeordnete Sammelschiene verstanden, insbesondere eine direkt auf der Beschichtung angeordneten Sammelschiene.

Die elektrisch leitfähige Beschichtung schützt dabei das elektrische Bauelement, insbesondere das Schichtsystem des elektrischen Bauelements, vor äußeren Einflüssen, wobei das Schichtsystem des elektrischen Bauelements nicht beschädigt wird, und stellt ergänzend eine elektrisch leitfähige Kontaktierung mindestens einer Frontelektrode und/oder Rückelektrode der mindestens einen Zelle des elektrischen Bauelements zu mindestens einer außerhalb der Beschichtung angeordneten Sammelschiene bereit.

In einer bevorzugten Ausführungsform der Erfindung weist das elektrische Bauelement ein Substrat auf, wobei das Schichtsystem auf dem Substrat angeordnet ist.

In einer bevorzugten Ausführungsform der Erfindung beträgt eine Viskosität des Präkursors, des Matrixmaterials und/oder des Dotanden einzeln oder als Mischung 0,1 mPas bis 2000 mPas, bevorzugt 0,1 mPas bis 1000 mPas, bevorzugt 1 mPas bis 2000 mPas, bevorzugt 1 mPas bis 1000 mPas, bevorzugt 1 mPas bis 500 mPas, bevorzugt 10 mPas bis 2000 mPas, bevorzugt 10 mPas bis 1000 mPas, oder bevorzugt 10 mPas bis 500 mPas. Dadurch ist insbesondere gewährleistet, dass die Beschichtung formschlüssig und/oder stoffschlüssig auf dem elektrischen Bauelement angeordnet ist, insbesondere der mindestens eine Graben mit der Beschichtung vollständig gefüllt ist.

In einer bevorzugten Ausführungsform der Erfindung ist das Schichtsystem der mindestens einen Zelle zur Verschaltung einzelner Zellen untereinander, und zur elektrischen Trennung von einzelnen Zellen strukturiert, insbesondere laser-strukturiert.

Unter einer Laserstrukturierung eines elektrischen Bauelements, insbesondere von einzelnen Schichten eines Schichtsystems und/oder eines vollständigen Schichtsystems, wird insbesondere eine Verschaltung einzelner Schichten des Schichtsystems und/oder Zellen auf einem elektrischen Bauelement, oder eine elektrische Trennung von Zellen verstanden. Zur Verschaltung einzelner Zellen untereinander wird insbesondere eine Frontelektrode einer ersten Zelle mit einer Rückelektrode einer zweiten Zelle elektrisch leitend verbunden. In einer bevorzugten Ausführungsform der Erfindung ist das elektrische Bauelement, insbesondere Zellen des elektrischen Bauelements untereinander, monolithisch verschaltet.

Unter einer Breite des mindestens einen Grabens wird insbesondere ein Abstand zwischen zwei gegenüberliegenden Teilen der Rückelektrode an einer elektrisch leitfähigen Unterbrechung der Rückelektrode durch den mindestens einen Graben verstanden.

In einer bevorzugten Ausführungsform der Erfindung beträgt ein Verhältnis der Breite des Grabens zu dem kürzesten Abstand zwischen der Sammelschiene und der Frontelektrode und/oder Rückelektrode mindestens 1:10, bevorzugt mindestens 1:20, bevorzugt mindestens 1:30, oder bevorzugt mindestens 1:100.

In einer bevorzugten Ausführungsform der Erfindung beträgt ein Abstand der Sammelschiene von dem mindestens einen Graben von 100 µm bis 100 mm, bevorzugt von 100 µm bis 10 mm, bevorzugt von 100 µm bis 1 mm, oder bevorzugt von 1 mm bis 10 mm, bezogen auf den kürzesten Abstand der Sammelschiene von dem Graben.

In einer bevorzugten Ausführungsform der Erfindung handelt es sich bei der Beschichtung um einen elektrisch leitfähigen Wickelschutz. Unter einem Wickelschutz wird insbesondere eine Schutzschicht zum Schutz eines elektrischen Bauelements vor Umwelteinflüssen und/oder einer Beschädigung verstanden. Nach dem Aufbringen der Beschichtung als Wickelschutz wird ein Transfer eines mit der Beschichtung beschichteten elektrischen Bauelements in eine weitere Anlage ermöglicht, in der weitere Bearbeitungsschritte vollzogen werden.

In einer bevorzugten Ausführungsform der Erfindung ist die Beschichtung formschlüssig und/oder stoffschlüssig auf dem elektrischen Bauelement angeordnet, insbesondere ist der mindestens eine Graben mit der Beschichtung formschlüssig und/oder stoffschlüssig gefüllt.

In einer bevorzugten Ausführungsform der Erfindung weist die mindestens eine Zelle eine Breite von 5 mm bis 50 mm auf, bevorzugt von 10 mm bis 30 mm.

In einer bevorzugten Ausführungsform der Erfindung weist eine Zelle eine Länge von 5 cm bis 20 m auf, bevorzugt von 50 cm bis 20 m, oder bevorzugt von 50 cm bis 10 m.

In einer bevorzugten Ausführungsform der Erfindung ist die Beschichtung zumindest weitgehend durchlässig für Licht im sichtbaren Wellenlängenbereich, insbesondere zumindest weitgehend transparent.

In einer besonders bevorzugten Ausführungsform der Erfindung ist die mindestens eine photoaktive Schicht aus organischen Materialien ausgebildet, bevorzugt aus kleinen organischen Molekülen oder polymeren organischen Molekülen, insbesondere bevorzugt aus kleinen organischen Molekülen. In einer bevorzugten Ausführungsform der Erfindung ist die organische photoaktive Schicht durch Verdampfen kleiner organischer Moleküle aufgebracht.

Unter kleinen Molekülen werden insbesondere Absorbermaterialien verstanden, die eine wohl definierte Anzahl von Monomeren, typischerweise kleiner zehn, umfassen und eine wohldefinierte Masse aufweisen, typischerweise von weniger als 1500g/mol, bevorzugt kleiner als 1200g/mol, und frei von undefinierten, möglicherweise reaktiven Gruppen am Ende der Molekülkette, wie sie als Nebenprodukt einer Polymerisations-Kettenreaktion in Polymeren vorliegen können, sind.

Die erfindungsgemäße elektrisch leitfähige Beschichtung eines elektrischen Bauelements weist Vorteile im Vergleich zum Stand der Technik auf. Vorteilhafterweise schützt die Beschichtung das Schichtsystem des elektrischen Bauelements, insbesondere auch vor und während der Endfertigung, vor Umwelteinflüssen und Beschädigungen, und stellt gleichzeitig eine elektrisch leitfähige Kontaktierung das Schichtsystem mit der mindestens einen Sammelschiene des photovoltaischen Elements bereit. Die spezifische Leitfähigkeit der Beschichtung ist dabei gering genug, dass diese eine monolithische Verschaltung des elektrischen Bauelements nicht beeinflusst. Die spezifische Leitfähigkeit der Beschichtung ist dabei hoch genug, dass der Widerstand zwischen Elektrode und Sammelschiene weitgehend keine zusätzlichen Verluste generiert. Vorteilhafterweise muss die Beschichtung zur elektrischen Kontaktierung des Schichtsystems mit einer außerhalb angeordneten Sammelschiene nicht nachträglich geöffnet werden. Vorteilhafterweise wird die Lebensdauer eines elektrischen Bauelements erhöht, da keine Öffnung der Beschichtung vorhanden ist durch die Feuchtigkeit ins Schichtsystem eindringen kann. Vorteilhafterweise sind keine weiteren Verfahrensschritte zur elektrisch leitfähigen Kontaktierung mit einer außerhalb der Beschichtung angeordneten Sammelschiene notwendig. Vorteilhafterweise ist das Verfahren in ein Rolle-zu-Rolle-Verfahren zur Herstellung eines elektrischen Bauelements integrierbar.

Unter einem Rolle-zu-Rolle Verfahren wird insbesondere die Herstellung flexibler elektrischer Bauteile verstanden, die auf eine Bahn aus flexiblen Kunststoff- oder Metallfolien aufgebracht werden, insbesondere in einer kontinuierliche Verfahrensführung. Das Rolle-zu-Rolle-Verfahren ist beispielsweise durch ein fortlaufendes Substrat, insbesondere aus einer Kunststofffolie, beispielsweise PET oder PEN, gekennzeichnet. Auf dieses Substrat werden zur Ausbildung elektrischer Bauelemente Materialien aufgetragen, insbesondere durch Aufdampfen, Drucken, Coaten, Sputtern oder Plasmaabscheiden.

Gemäß einer Weiterbildung der Erfindung ist vorgesehen, dass ein Verhältnis der Schichtdicke der Beschichtung zu der Breite des mindestens einen Grabens mindestens 1:10 beträgt, bevorzugt mindestens 1:20, bevorzugt mindestens 1:30, bevorzugt mindestens 1:100, bevorzugt mindestens 1:1000, bevorzugt 1:5 bis 1:5000, bevorzugt 1:10 bis 1:10000, bevorzugt 1:10 bis 1:1000, bevorzugt 1:20 bis 1:500, oder bevorzugt 1:20 bis 1:200.

Gemäß einer Weiterbildung der Erfindung ist vorgesehen, dass eine Breite des mindestens einen Grabens 1 µm bis 1 mm beträgt, bevorzugt 10 µm bis 1 mm, bevorzugt 50 µm bis 1 mm, bevorzugt 1 µm bis 400 µm, bevorzugt 10 µm bis 400 µm, oder bevorzugt 10 µm bis 200 µm.

Gemäß einer Weiterbildung der Erfindung ist vorgesehen, dass eine Schichtdicke der Beschichtung 100 nm bis 100 µm beträgt, bevorzugt 500 nm bis 10 µm.

Gemäß einer Weiterbildung der Erfindung ist vorgesehen, dass ein Verhältnis einer Schichtdicke der Rückelektrode zu einer Breite der ersten Sammelschiene mindestens 1:10 beträgt, bevorzugt mindestens 1:30, bevorzugt 1:5 bis 1:5000, bevorzugt 1:10 bis 1:1000, oder bevorzugt 1:20 bis 1:200.

Gemäß einer Weiterbildung der Erfindung ist vorgesehen, dass die Breite der ersten Sammelschiene 0,1 cm bis 30 cm beträgt, bevorzugt 0,1 cm bis 20 cm, bevorzugt 0,1 cm bis 10 cm, bevorzugt 0,5 cm bis 30 cm, bevorzugt 0,5 cm bis 20 cm, bevorzugt 0,5 cm bis 10 cm, bevorzugt 0,5 cm bis 5 cm, oder bevorzugt 1 cm bis 3 cm.

Gemäß einer Weiterbildung der Erfindung ist vorgesehen, dass die Schichtdicke der Rückelektrode 10 nm bis 1 µm beträgt, bevorzugt 10 nm bis 500 nm, bevorzugt 20 nm bis 500 nm, oder bevorzugt 50 nm bis 500 nm.

In einer bevorzugten Ausführungsform der Erfindung beträgt ein Verhältnis der Breite des Grabens zu der Breite der Sammelschiene mindestens 1:10, bevorzugt mindestens 1:20, bevorzugt mindestens 1:30, bevorzugt mindestens 1:50, bevorzugt mindestens 1:100, bevorzugt mindestens 1:200, bevorzugt mindestens 1:500, oder bevorzugt mindestens 1:1000.

Gemäß einer Weiterbildung der Erfindung ist vorgesehen, dass die Beschichtung einen spezifischen Widerstand von 0,1 bis 1000 Ωm aufweist, bevorzugt von 1 bis 1000 Ωm, bevorzugt von 1 bis 500 Ωm, bevorzugt von 1 bis 200 Ωm, bevorzugt von 10 bis 1000 Ωm, bevorzugt von 10 bis 500 Ωm, bevorzugt von 100 bis 1000 Ωm, oder bevorzugt von 100 bis 500 Ωm.

In einer bevorzugten Ausführungsform der Erfindung weist die Beschichtung eine spezifische Leitfähigkeit von 100 bis 0,0001 S/m auf, bevorzugt von 10 bis 0,001 S/m.

Gemäß einer Weiterbildung der Erfindung ist vorgesehen, dass das Verhältnis des elektrischen Widerstands zwischen der Rückelektrode und der ersten Sammelschiene der Beschichtung (R_{Schicht}) und dem elektrischen Widerstand über der Breite des Grabens mit der Beschichtung (R_{Graben}) mindestens 1:100, bevorzugt mindestens 1:500, bevorzugt mindestens 1:1000, bevorzugt mindestens 1:2000, bevorzugt mindestens 1:5000, oder bevorzugt mindestens 1:10000, bevorzugt von 1:100 bis 1:100000, bevorzugt von 1:1000 bis 1:100000, oder bevorzugt von 1:10000 bis 1:100000.

In einer bevorzugten Ausführungsform der Erfindung ist das Schichtsystem derart strukturiert, dass die mindestens eine photoaktive Schicht unterbrochen ist, und die Frontelektrode und die Rückelektrode der mindestens einen Zelle über die Unterbrechung der mindestens einen photoaktiven Schicht elektrisch leitfähig miteinander verbunden sind, wobei die Frontelektrode durch den mindestens einen Graben von der Rückelektrode elektrisch leitfähig getrennt ist. Die Frontelektrode ist über einen Teil der Rückelektrode mit einer außerhalb der Beschichtung angeordneten zweiten Sammelschiene elektrisch leitfähig kontaktiert, wobei der elektrische Widerstand von der Rückelektrode über den mindestens einen Graben mit der Beschichtung größer ist als der elektrische Widerstand durch die Beschichtung zwischen der Frontelektrode und der zweiten Sammelschiene.

In einer bevorzugten Ausführungsform der Erfindung beträgt das Verhältnis des elektrischen Widerstands zwischen der Frontelektrode und der zweiten Sammelschiene der Beschichtung (R_{Schicht}) und dem elektrischen Widerstand über die Breite des Grabens mit der Beschichtung (R_{Graben}) mindestens 1:100, bevorzugt mindestens 1:500, bevorzugt mindestens 1:1000, bevorzugt mindestens 1:2000, bevorzugt mindestens 1:5000, oder bevorzugt mindestens 1:10000, bevorzugt von 1:100 bis 1:100000, bevorzugt von 1:1000 bis 1:100000, oder bevorzugt von 1:10000 bis 1:100000.

In einer bevorzugten Ausführungsform der Erfindung beträgt eine Breite der zweiten Sammelschiene 0,1 cm bis 30 cm beträgt, bevorzugt 0,1 cm bis 20 cm, bevorzugt 0,1 cm bis 10 cm, bevorzugt 0,1 cm bis 5 cm, bevorzugt 0,5 cm bis 30 cm, bevorzugt 0,5 cm bis 20 cm, bevorzugt 0,5 cm bis 10 cm, bevorzugt 0,5 cm bis 5 cm, bevorzugt 1 cm bis 10 cm, bevorzugt 1 cm bis 5 cm, oder bevorzugt 1 cm bis 2 cm.

In einer bevorzugten Ausführungsform der Erfindung beträgt ein Verhältnis einer Schichtdicke der Rückelektrode zu einer Breite der zweiten Sammelschiene mindestens 1:10 beträgt, bevorzugt mindestens 1:30, bevorzugt 1:5 bis 1:5000, bevorzugt 1:10 bis 1:1000, oder bevorzugt 1:20 bis 1:200.

In einer bevorzugten Ausführungsform der Erfindung beträgt der Abstand zwischen der ersten Sammelschiene und der zweiten Sammelschiene mindestens 150% der Breite des mindestens einen Grabens, bevorzugt mindestens 200%, bevorzugt mindestens 300%, bevorzugt mindestens 500%, oder bevorzugt mindestens 1000%.

Gemäß einer Weiterbildung der Erfindung ist vorgesehen, dass das mindestens eine Schichtsystem derart strukturiert ist, dass die Strukturierung einen Graben eines ersten Typs (P3), der die Rückelektrode elektrisch leitfähig unterbricht, einen Graben eines zweiten Typs (P1), der die Frontelektrode elektrisch leitfähig unterbricht, und einen Graben eines dritten Typs (P2), der die mindestens eine photoaktive Schicht elektrisch leitfähig unterbricht, aufweist, so dass die Frontelektrode und die Rückelektrode der mindestens einen Zelle elektrisch leitfähig miteinander verschaltet sind.

In einer bevorzugten Ausführungsform der Erfindung sind mehrere Zellen des photovoltaischen Elements nebeneinander angeordnet und in Reihe verschaltet. Jede Zelle hat dabei eine eigene Elektrode und Gegenelektrode, wobei die Reihenschaltung durch elektrisches Verbinden der Elektrode einer Zelle mit der Gegenelektrode der nächsten Zelle erfolgt.

Gemäß der Erfindung ist vorgesehen, dass die Beschichtung auf einer Vorderseite des elektrischen Bauelements und/oder auf einer Rückseite des elektrischen Bauelements ausgebildet ist, bevorzugt ist die Beschichtung über die vollständige Ausdehnung des elektrischen Bauelements ausgebildet.

In einer bevorzugten Ausführungsform der Erfindung ist die Beschichtung über die gesamte Oberfläche des elektrischen Bauelements angeordnet.

Gemäß einer Weiterbildung der Erfindung ist vorgesehen, dass die Beschichtung gebildet ist aus:
a) mindestens einem Präkursor ausgewählt aus der Gruppe bestehend aus Hexamethyldisiloxan (HMDSO), bis-Trimethylsilymethan (BTMSM), Tetraethylorthosilikat (TEOS), Hexamethyldisilazan (HMDSN), Silan (SiH₄), Triethoxysilan (TriEOS), Tetramethoxysilan (TMOS), Tetramethylsilan (TMS), und Trimethoxysilan (TriMOS), bis-Diethylamino-Silan (BTBAS), bevorzugt unter Verwendung eines Reaktionsgases ausgewählt aus Stickstoff oder Sauerstoff; oder
b) mindestens einem Matrixmaterial ausgewählt aus a), Siliciumoxycarbiden, bevorzugt SiOC oder SiOCH, oder einem SiOCH-ähnlichen Material, bevorzugt Siliciumcarboxynitriden (SiONCH), Siliciumcarbonitriden (SiNCH), Siliciumnitriden (SiN), Silicaten (SiO₂), und Al₂O₃; oder
c) mindestens einem Material ausgewählt aus b) und mindestens einem Dotanden, wobei der Dotand ausgewählt ist aus der Gruppe bestehend aus Diboran, Trimethyl-Bor, und Phosphin, oder einem TCO Material, bevorzugt ausgewählt aus der Gruppe bestehend aus Metall-Alkoxiden, Metall-Amiden, bevorzugt Titan-Alkoxid, insbesondere bevorzugt Titantetraisobutoxid, Titan-tetraisoethoxid, und Titan-tetraisomethoxid, Titan-tetra-isopropoxid (TTIP), TiCl₄, Dialkyl-Zink, bevorzugt Dimethyl-Zink oder Diethyl-Zink (DEZN), Zinnchlorid, Tetramethylzinn, Tetraethylzinn, ITO, In₂O₃, TiO₂, ZnO, und SnO₂.

In einer besonders bevorzugten Ausführungsform der Erfindung ist das Matrixmaterial der Beschichtung SiOCH oder ein SiOCH ähnliche Material. SiOCH ist ein Siliziumoxid (SiOx), das mittels eines Kohlenstoff-Anteils organische Eigenschaften erhält, d.h. es kommt durch den Kohlenstoff-Anteil zu einer Beeinflussung des chemischen Gefüges und der polymerartigen, teilvernetzten Kettenstruktur. Das Material ist elastischer und flexibler als SiOx, es handelt sich um ein nanoporöses Material, das flexible und elastische Eigenschaften aufweist.

In einer bevorzugten Ausführungsform der Erfindung umfasst die Beschichtung einen Kohlenstoffanteil größer als 15 at%, bevorzugt größer als 20 at%, besonders bevorzugt größer als 25 at%.

In einer bevorzugten Ausführungsform der Erfindung weist die Beschichtung, einen Anteil des mindestens einen Dotanden von 0,1 bis 50 Gew.-% auf, bevorzugt von 0,1 bis 20 Gew.-%, bevorzugt von 0,1 bis 10 Gew.-%, bevorzugt von 0,5 bis 10 Gew.-%, bevorzugt von 1 bis 10 Gew.-%, bevorzugt von 1 bis 5 Gew.-%, oder bevorzugt von 1 bis 3 Gew.-%, bezogen auf das Gesamtgewicht der Beschichtung.

In einer bevorzugten Ausführungsform der Erfindung weist die Beschichtung flexible Eigenschaften auf, wobei eine Elastizität (modulus of elasticity) der Beschichtung von 80000 psi bis 360000 psi beträgt, bevorzugt 100000 psi bis 300000 psi, bevorzugt 120000 psi bis 260000 psi, oder bevorzugt 100000 psi bis 200000 psi.

Die Aufgabe der vorliegenden Erfindung wird auch gelöst, indem eine Verwendung einer erfindungsgemäßen elektrisch leitfähigen Beschichtung als Schutzschicht eines elektrischen Bauelements, insbesondere als Wickelschutz, und zur elektrisch leitfähigen Kontaktierung zumindest einer Rückelektrode eines Schichtsystems mit einer ersten Sammelschiene des elektrischen Bauelements bereitgestellt wird, insbesondere nach einem der zuvor beschriebenen Ausführungsbeispiele.

Die Aufgabe der vorliegenden Erfindung wird auch gelöst, indem ein elektrisches Bauelement mit einer erfindungsgemäßen elektrisch leitfähigen Beschichtung bereitgestellt wird, insbesondere nach einem der zuvor beschriebenen Ausführungsbeispiele. Dabei ergeben sich für das elektrische Bauelement insbesondere die Vorteile, die bereits in Zusammenhang mit der elektrisch leitfähigen Beschichtung und der Verwendung der elektrisch leitfähigen Beschichtung beschrieben wurden. Das elektrische Bauelement weist dabei mindestens ein Schichtsystem mit einer Frontelektrode, einer Rückelektrode, und mindestens einer photoaktiven Schicht, wobei die mindestens eine photoaktive Schicht zwischen der Frontelektrode und der Rückelektrode angeordnet ist, und mindestens eine Sammelschiene auf, wobei die Beschichtung zwischen dem mindestens einen Schichtsystem und der mindestens einen Sammelschiene angeordnet ist, so dass zumindest die Rückelektrode mit der mindestens einen Sammelschiene elektrisch leitfähig kontaktiert ist, wobei das elektrische Bauelement bevorzugt ein photovoltaisches Element ist.

In einer bevorzugten Ausführungsform der Erfindung ist das elektrische Bauelement ein organisches elektrisches Bauelement, bevorzugt ein organisches photovoltaisches Element (OPV), ein OFET, eine OLED oder ein organischer Photodetektor.

In einer bevorzugten Ausführungsform der Erfindung ist das elektrische Bauelement ein flexibles elektrisches Bauelement. Unter einem flexiblen elektrischen Bauelement wird insbesondere ein elektrisches Bauelement verstanden, dass in einem bestimmten Bereich biegbar und/oder dehnbar ist. In einer bevorzugten Ausführungsform der Erfindung ist das flexible elektrische Bauelement ein flexibles photovoltaisches Element, insbesondere ein flexibles organisches photovoltaisches Element.

In einer bevorzugten Ausführungsform der Erfindung ist das elektrische Bauelement ein Halbfabrikat, entsprechend ist das elektrische Bauelement, auf das die Beschichtung aufgetragen wird, ein Halbfabrikat zur Herstellung eines endgefertigten elektrischen Bauelements.

Unter einem Halbfabrikat wird insbesondere eine Vorstufe eines elektrischen Bauelements verstanden, bei dem mindestens ein weiterer Verfahrensschritt notwendig ist, also eine weitere Verarbeitung notwendig ist, um ein endgefertigtes elektrisches Bauelement zu erhalten. Vorzugsweise wird unter einem Halbfabrikat ein elektrische Bauelement, insbesondere eine photovoltaische Zelle, verstanden, welches noch keine Schutzschicht oder noch nicht alle Schutzschichten aufweist und/oder noch nicht verkapselt ist. Dagegen ist das elektrische Bauelement nach der Endfertigung bevorzugt mit allen Schutzschichten versehen und/oder verkapselt, insbesondere mit den notwendigen Anschlüssen für eine elektrische Kontaktierung ausgestattet.

Die Aufgabe der vorliegenden Erfindung wird auch gelöst, indem ein Verfahren zum Beschichten eines elektrischen Bauelements gemäß den Ansprüchen mit einer erfindungsgemäßen elektrisch leitfähigen Beschichtung bereitgestellt wird, insbesondere nach einem der zuvor beschriebenen Ausführungsbeispiele. Dabei ergeben sich für das Verfahren zum Beschichten eines elektrischen Bauelements insbesondere die Vorteile, die bereits in Zusammenhang mit der elektrisch leitfähigen Beschichtung, der Verwendung der elektrisch leitfähigen Beschichtung, und dem elektrischen Bauelement mit der elektrisch leitfähigen Beschichtung beschrieben wurden. Das Verfahren umfasst dabei die folgenden Schritte:
a) Bereitstellen eines elektrischen Bauelements mit mindestens einer Zelle mit mindestens einem strukturierten Schichtsystem, aufweisend eine Frontelektrode, eine Rückelektrode, und mindestens eine photoaktive Schicht, die zwischen der Frontelektrode und der Rückelektrode angeordnet ist, wobei die Rückelektrode durch mindestens einen Graben unterbrochen ist;
b) Auftragen mindestens eines Präkursors, eines Matrixmaterials und/oder eines Dotanden gleichzeitig oder als Mischung mittels eines Abscheideverfahrens oder eines Druckverfahrens zumindest auf die Rückelektrode und in den mindestens einen Graben der Rückelektrode, so dass zumindest die Rückelektrode vollständig bedeckt wird; und
c) Erhalten der Beschichtung.

Gemäß einer Weiterbildung der Erfindung ist vorgesehen, dass nach Schritt c) in einem Schritt d) zumindest eine erste Sammelschiene auf die Beschichtung aufgebracht wird.

In einer bevorzugten Ausführungsform der Erfindung wird das Verfahren gemäß den Ansprüchen in einem Rolle-zu-Rolle Verfahren durchgeführt, bevorzugt einem kontinuierlichen Rolle-zu-Rolle Verfahren. Bei einem Rolle-zu-Rolle Verfahren ist das Substrat insbesondere auf eine Rolle aufgerollt und läuft dadurch kontinuierlich in eine geschlossene Anlage ein. Dort wird das Schichtsystem gebildet. Vorzugsweise erfolgt die Fertigung des Schichtsystems unter Vakuum. Handelt es sich bei dem elektrischen Bauelement um ein Halbfabrikat, so kann das Halbfabrikat der weiteren Bearbeitung zugeführt werden.

In einer bevorzugten Ausführungsform der Erfindung wird mindestens ein Verfahrensschritt des Verfahrens, bevorzugt zumindest Schritt b), unter Schutzgas durchgeführt, bevorzugt Stickstoff oder Argon.

In einer bevorzugten Ausführungsform der Erfindung ist das Abscheideverfahren ein Atomlagenabscheideverfahren (ALD), ein plasmaunterstütztes Atomlagenabscheideverfahren (PEALD), ein plasmaloses Atomlageabscheideverfahren (PLALD), ein chemisches Gasphasenabscheideverfahren (CVD), ein plasmaunterstütztes Gasphasenabscheideverfahren (PECVD), ein Mikrowellen-PECVD-Verfahren, ein plasmaloses Gasphasenabscheideverfahren (PLCVD), oder ein Hohl-Kathoden-Verfahren.

In einer bevorzugten Ausführungsform der Erfindung ist das Druckverfahren ein Siebdruck-Verfahren, ein Plot-Verfahren, ein Tintenstrahldruck-Verfahren, ein 3D-Druck-Verfahren, ein Schlitzdüsenverfahren, ein Kommabarverfahren, oder ein Rakelverfahren.

In einer bevorzugten Ausführungsform der Erfindung ist der Beschichtungsdruck kleiner als 50 Pa, bevorzugt kleiner als 10 Pa, besonders bevorzugt kleiner als 5 Pa.

In einer bevorzugten Ausführungsform der Erfindung wird die Beschichtung nach dem Auftragen in Schritt b) mittels UV-härtens, Dualhärtens, thermischem Härtens, und/oder eines Reaktionsgases ausgehärtet.

In einer bevorzugten Ausführungsform der Erfindung ist der Anteil des Reaktionsgases zum Gesamt-Volumen des mindestens einen Präkursors und Reaktionsgases größer als 4 Vol%, bevorzugt größer als 6 Vol%, und kleiner als 20 Vol%, bevorzugt kleiner als 10 Vol%.

In einer bevorzugten Ausführungsform der Erfindung wird die Beschichtung bei einer Temperatur des elektrischen Bauelements bzw. des Schichtsystems von -20°C bis 110°C aufgetragen, bevorzugt von - 10°C bis 50°C, bevorzugt von 0°C bis 60°C, bevorzugt von 5°C bis 40°C, bevorzugt von 5°C bis 30°C, bevorzugt von 10°C bis 50°C, bevorzugt von 20°C bis 40°C, oder bevorzugt von 30°C bis 50°C.

Die Erfindung wird im Folgenden anhand der Zeichnungen näher erläutert. Die Ausführungsbeispiele beziehen sich insbesondere auf ein in einem Rolle-zu-Rolle Verfahren hergestelltes elektrisches Bauelement. Dabei zeigen:
Fig. 1 eine schematische Darstellung eines Ausführungsbeispiels eines Schichtsystems eines elektrischen Bauelements im Querschnitt;
Fig. 2 eine schematische Darstellung eines Ausführungsbeispiels eines strukturierten Schichtsystems eines elektronischen Bauelements;
Fig. 3 eine schematische Darstellung eines Ausführungsbeispiels eines elektrischen Bauelements mit einer elektrisch leitfähigen Beschichtung im Querschnitt; und
Fig. 4 eine schematische Darstellung eines Ausführungsbeispiels eines Verfahrens zur Herstellung einer elektrisch leitfähigen Beschichtung eines elektrischen Bauelements in einem Fließdiagramm.

### Ausführungsbeispiele

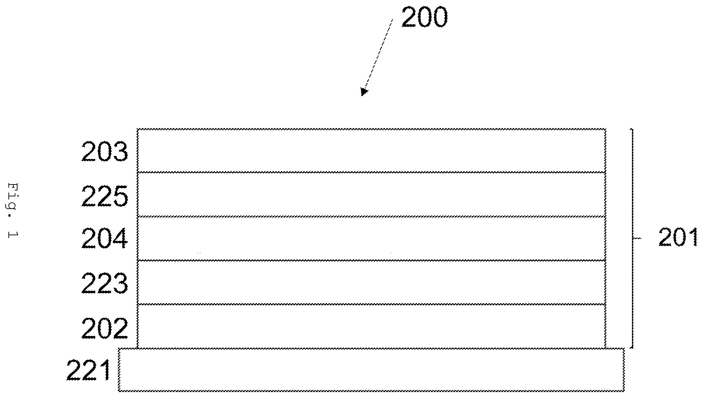

Fig. 1 zeigt eine schematische Darstellung eines Ausführungsbeispiels eines Schichtsystems 201 eines elektrischen Bauelements 200 im Querschnitt.

In diesem Ausführungsbeispiel ist das elektrische Bauelement 200 ein photovoltaisches Element. Das photovoltaische Element besteht aus einer Folge dünner Schichten mit dem Schichtsystem 201, mit mindestens einer photoaktiven Schicht 204, welche bevorzugt im Vakuum aufgedampft oder aus einer Lösung prozessiert werden. Die elektrische Anbindung erfolgt über Elektroden, z.B. durch Metallschichten, transparente leitfähige Oxide und/oder transparente leitfähige Polymere.

Das photovoltaische Element weist ein Substrat 221 auf, z.B. aus Glas, auf dem sich ein Schichtsystem 201 befindet. Das Schichtsystem 201 umfasst eine Frontelektrode 202 auf, die z.B. ITO aufweist, eine n-dotierte Elektronentransportschicht 223, sowie eine photoaktive Schicht 204, Darüber angeordnet befindet sich eine p-dotierte Lochtransportschicht 225, und eine Rückelektrode 203 aus Aluminium.

Die photoaktive Schicht 204 ist in diesem Ausführungsbeispiel eine organische photoaktive Schicht mit einem Donor/Akzeptor-System aus kleinen Molekülen.

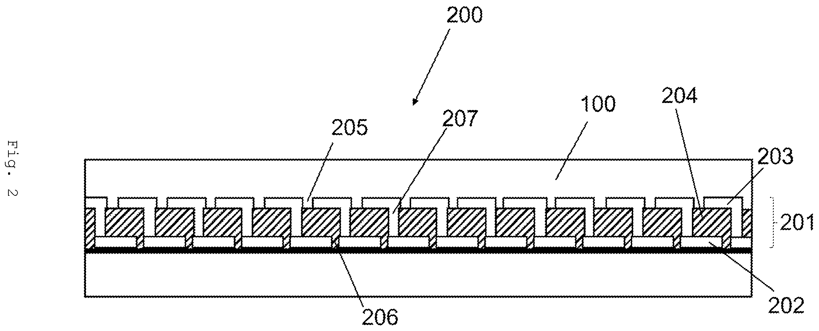

Fig. 2 zeigt eine schematische Darstellung eines Ausführungsbeispiels eines strukturierten Schichtsystems 201 eines elektronischen Bauelements 200. Gleiche und funktionsgleiche Elemente sind mit den gleichen Bezugszeichen versehen, so dass insofern auf die vorangegangene Beschreibung verwiesen wird.

Das bereitgestellte Substrat 221 wird in diesem Ausführungsbeispiel mit einer Schicht einer Frontelektrode 202 beschichtet und strukturiert, wobei die Graben 206 (P1) erhalten werden. Anschließend wird zumindest die photoaktive Schicht 204 auf die Frontelektrode 202 aufgebracht. Das Aufbringen einzelner Schichten kann zumindest teilweise durch einen Druckprozess, bevorzugt durch einen Injket-, Siebdruck-, Gravuredruck- oder Flexoprintprozess, oder mittels Verdampfens der aufzubringenden Materialien im Vakuum erfolgen. Die mindestens eine photoaktive Schicht 204 wird strukturiert, wobei die Graben 207 (P2) erhalten werden. Auf die strukturierte photoaktive Schicht 204 wird die Schicht der Rückelektrode 203 aufgebracht und strukturiert, wobei die Graben 205 (P3) erhalten werden. Das elektrische Bauelement 200 ist in dem vorliegenden Ausführungsbeispiel ein photovoltaisches Element.

Ein Ausführungsbeispiel einer Strukturierung eines Schichtsystems 201 eines elektrischen Bauelements 200 mit den Strukturierungen P1, P2, und P3 ist in Fig. 2 dargestellt. Die Strukturierung weist folgende Grabenstruktur auf: einen Graben 205 eines ersten Typs (P3), welcher eine Schicht einer Frontelektrode 202 unterbricht, einen Graben 206 eines zweiten Typs (P1), welcher eine Schicht einer Rückelektrode 203 unterbricht, und einen Graben 207 eines dritten Typs (P2), welche eine photoaktive Schicht 204 unterbricht. Die Graben 207 des dritten Typs (P2) sind mit einem elektrisch leitfähigen Material zur elektrischen Kontaktierung der Rückelektrode 203 mit der Frontelektrode 202 gefüllt. Dadurch wird die Frontelektrode 202 durch die photoaktive Schicht 204 elektrisch leitfähig hindurchgeführt.

Die Strukturierung des Schichtsystems 201, insbesondere der Frontelektrode 202, der Rückelektrode 203, und der mindestens einen photoaktiven Schicht 204, kann mittels Laserablation, Elektronen- oder Ionenstrahlablation, Ritzen oder Schattenmasken erfolgen.

Für die Strukturierungen P1 / P2 / P3 mittels eines Lasers können folgende Parameter verwendet werden: P1: 1030 nm Wellenlänge und 50 µm Linienbreite; P2: 515 nm Wellenlänge und 50 µm Linienbreite, und P3: 1030 nm Wellenlänge und 100 µm Linienbreite. In diesem Ausführungsbeispiel beträgt die Breite der Graben 205 des Typs P3 100 µm und die Breite der Sammelschiene 300 14 mm.

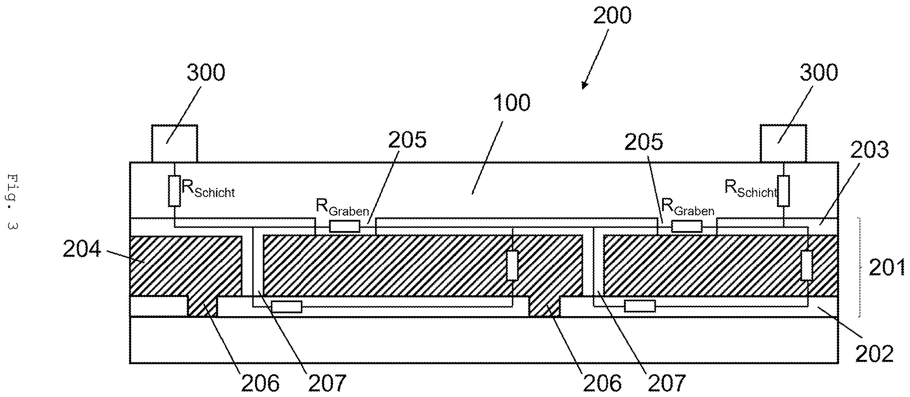

In einem Ausführungsbeispiel ist das Substrat 221 eine Folie, beispielsweise eine PET-Folie. Auf das Substrat 221 werden die einzelnen Schichten des Schichtsystems 201 des photovoltaischen Elements 300 aufgebracht und strukturiert (siehe Fig. 3). Die Schichten können beispielsweise mittels eines PECVD-Verfahrens aufgetragen werden.

Fig. 3 zeigt eine schematische Darstellung eines Ausführungsbeispiels eines elektrischen Bauelements 200 mit einer elektrisch leitfähigen Beschichtung 100 im Querschnitt. Gleiche und funktionsgleiche Elemente sind mit den gleichen Bezugszeichen versehen, so dass insofern auf die vorangegangene Beschreibung verwiesen wird.

In diesem Ausführungsbeispiel ist das elektrische Bauelement 200 ein photovoltaisches Element. Das elektrische Bauelement 200 weist ein strukturiertes Schichtsystem 201 auf.

Die elektrisch leitfähige Beschichtung 100 eines elektrischen Bauelements 200 zur elektrisch leitfähigen Kontaktierung einer außerhalb der Beschichtung 100 angeordneten ersten Sammelschiene 300, weist mindestens eine Zelle mit mindestens einem strukturierten Schichtsystem 201 auf, wobei das mindestens eine Schichtsystem 201 eine Frontelektrode 202, eine Rückelektrode 203, und mindestens eine photoaktive Schicht 204 aufweist, wobei die mindestens eine photoaktive Schicht 204 zwischen der Frontelektrode 202 und der Rückelektrode 203 angeordnet ist. Das mindestens eine Schichtsystem 201 ist derart strukturiert, dass die Rückelektrode 203 durch mindestens einen Graben 205 unterbrochen ist, und zumindest die Rückelektrode 203 der mindestens einen Zelle mit der Beschichtung 100 beschichtet und der mindestens eine Graben 205 der Rückelektrode 203 mit der Beschichtung 100 gefüllt ist. Die Beschichtung 100 weist einen spezifischen Widerstand von 0,01 bis 10000 Ωm auf, wobei ein Verhältnis des elektrischen Widerstands zwischen der Rückelektrode 203 und der ersten Sammelschiene 300 der Beschichtung 100 (R_{Schicht}) und dem elektrischen Widerstand über der Breite des Grabens 205 mit der Beschichtung 100 (R_{Graben}) mindestens 1:1000 beträgt.

Die elektrisch leitfähige Beschichtung 100 schützt das elektrische Bauelement 200, insbesondere das mindestens eine Schichtsystem 201 des elektrischen Bauelements 200, vor, während und nach der Endfertigung vor Umwelteinflüssen und Beschädigungen, und stellt gleichzeitig eine elektrische leitfähige Kontaktierung des Schichtsystems 201, insbesondere mindestens einer Elektrode 202,203 des Schichtsystems 201, mit einem außerhalb der Beschichtung 100 angeordneten Sammelschiene 300 bereit. Durch die Dimensionierung der P3 Graben (205) im Verhältnis zur Schichtdicke der Beschichtung 100 und dem spezifischen Widerstand der Beschichtung 100 ist der elektrische Widerstand zwischen Sammelschiene 300 und Rückseitenelektrode 203 klein genug zur Kontaktierung der Rückseitenelektrode (203), und der elektrische Widerstand zwischen der Sammelschiene 300 und Frontelektrode 202 groß genug, um signifikante Verluste eines generierten elektrischen Stroms zu vermeiden.

In einer Ausgestaltung der Erfindung beträgt ein Verhältnis der Schichtdicke der Beschichtung 100 zu der Breite des mindestens einen Grabens 205 mindestens 1:10, bevorzugt mindestens 1:30, bevorzugt 1:5 bis 1:5000, bevorzugt 1:10 bis 1:1000, oder bevorzugt 1:20 bis 1:200.

In einer weiteren Ausgestaltung der Erfindung beträgt eine Breite des mindestens einen Grabens 205 1 µm bis 1 mm, bevorzugt 10 µm bis 400 µm, und eine Schichtdicke der Beschichtung 100 nm bis 100 µm, bevorzugt 500 nm bis 10 µm.

In einer weiteren Ausgestaltung der Erfindung beträgt ein Verhältnis einer Schichtdicke der Rückelektrode 203 zu einer Breite der ersten Sammelschiene 300 mindestens 1:10, bevorzugt mindestens 1:30, bevorzugt 1:5 bis 1:5000, bevorzugt 1:10 bis 1:1000, oder bevorzugt 1:20 bis 1:200.

In einer weiteren Ausgestaltung der Erfindung beträgt die Breite der ersten Sammelschiene 300 0,1 cm bis 10 cm, bevorzugt 0,5 cm bis 5 cm, oder bevorzugt 1 cm bis 3 cm.

In einer weiteren Ausgestaltung der Erfindung beträgt die Schichtdicke der Rückelektrode 203 10 nm bis 1 µm, bevorzugt 20 nm bis 500 nm.

In einer weiteren Ausgestaltung der Erfindung weist die Beschichtung 100 einen spezifischen Widerstand von 0,1 bis 1000 Ωm auf, bevorzugt von 1 bis 500 Ωm, oder bevorzugt von 10 bis 500 Ωm.

In einer weiteren Ausgestaltung der Erfindung beträgt das Verhältnis des elektrischen Widerstands zwischen der Rückelektrode 203 und der ersten Sammelschiene 300 der Beschichtung 100 (R_{Schicht}) und dem elektrischen Widerstand über der Breite des Grabens 205 mit der Beschichtung 100 (R_{Graben}) mindestens 1:5000, bevorzugt mindestens 1:10000, bevorzugt von 1:1000 bis 1:100000, oder bevorzugt von 1:10000 bis 1:100000.

In einer weiteren Ausgestaltung der Erfindung ist das mindestens eine Schichtsystem 201 derart strukturiert, dass die Strukturierung einen Graben 205 eines ersten Typs (P3), der die Rückelektrode 203 elektrisch leitfähig unterbricht, einen Graben 206 eines zweiten Typs (P1), der die Frontelektrode 202 elektrisch leitfähig unterbricht, und einen Graben 207 eines dritten Typs (P2), der die mindestens eine photoaktive Schicht 204 elektrisch leitfähig unterbricht, aufweist, so dass die Frontelektrode 202 und die Rückelektrode 203 der mindestens einen Zelle elektrisch leitfähig miteinander verschaltet sind.

In einer weiteren Ausgestaltung der Erfindung ist die Beschichtung 100 auf einer Vorderseite des elektrischen Bauelements 200 und/oder auf einer Rückseite des elektrischen Bauelements 200 ausgebildet, bevorzugt ist die Beschichtung über die vollständige Ausdehnung des elektrischen Bauelements 200 ausgebildet.

In einer weiteren Ausgestaltung der Erfindung ist die Beschichtung 100 gebildet aus:
a) mindestens einem Präkursor ausgewählt aus der Gruppe bestehend aus Hexamethyldisiloxan (HMDSO), bis-Trimethylsilymethan (BTMSM), Tetraethylorthosilikat (TEOS), Hexamethyldisilazan (HMDSN), Silan (SiH₄), Triethoxysilan (TriEOS), Tetramethoxysilan (TMOS), Tetramethylsilan (TMS), und Trimethoxysilan (TriMOS), bis-Diethylamino-Silan (BTBAS), bevorzugt unter Verwendung eines Reaktionsgases ausgewählt aus Stickstoff oder Sauerstoff; oder
b) mindestens einem Matrixmaterial ausgewählt aus a), Siliciumoxycarbiden, bevorzugt SiOC oder SiOCH, oder einem SiOCH-ähnlichen Material, bevorzugt Siliciumcarboxynitriden (SiONCH), Siliciumcarbonitriden (SiNCH), Siliciumnitriden (SiN), Silicaten (SiO₂), und Al₂O₃; oder
c) mindestens einem Material ausgewählt aus b) und mindestens einem Dotanden, wobei der Dotand ausgewählt ist aus der Gruppe bestehend aus Diboran, Trimethyl-Bor, und Phosphin, oder einem TCO Material, bevorzugt ausgewählt aus der Gruppe bestehend aus Metall-Alkoxiden, Metall-Amiden, bevorzugt Titan-Alkoxid, insbesondere bevorzugt Titantetraisobutoxid, Titan-tetraisoethoxid, und Titan-tetraisomethoxid, Titan-tetra-isopropoxid (TTIP), TiCl₄, Dialkyl-Zink, bevorzugt Dimethyl-Zink oder Diethyl-Zink (DEZN), Zinnchlorid, Tetramethylzinn, Tetraethylzinn, ITO, In₂O₃, TiO₂, ZnO, und SnO₂.

Die elektrisch leitfähige Beschichtung 100 kann als Schutzschicht eines elektrisches Bauelements 200, insbesondere als Wickelschutz, und zur elektrisch leitfähigen Kontaktierung zumindest einer Rückelektrode 203 eines Schichtsystems 201 mit einer ersten Sammelschiene 300 des elektrischen Bauelements 200 verwendet werden.

In einer weiteren Ausgestaltung der Erfindung weist die Beschichtung 100 eine Elastizität von 80000 psi bis 360000 psi auf, bevorzugt von 100000 psi bis 300000 psi, bevorzugt von 120000 psi bis 260000 psi, oder bevorzugt von 100000 psi bis 200000 psi.

Das elektrisches Bauelement 200 mit der elektrisch leitfähigen Beschichtung 100 weist mindestens ein Schichtsystem 201 mit einer Frontelektrode 202, einer Rückelektrode 203, und mindestens einer photoaktiven Schicht 204, wobei die mindestens eine photoaktive Schicht 204 zwischen der Frontelektrode 202 und der Rückelektrode 203 angeordnet ist, und mindestens einer Sammelschiene 300 auf, wobei die Beschichtung 100 zwischen dem mindestens einen Schichtsystem 201 und der mindestens einen Sammelschiene 300 angeordnet ist, so dass zumindest die Rückelektrode 203 mit der mindestens einen Sammelschiene 300 elektrisch leitfähig kontaktiert ist. In diesem Ausführungsbeispiel ist das elektrische Bauelement 200 ein photovoltaisches Element.

In einer Ausgestaltung der Erfindung ist das elektrische Bauelement 200 ein organisches elektrisches Bauelement 200, bevorzugt ein organisches photovoltaisches Element (OPV), ein OFET, eine OLED oder ein organischer Photodetektor.

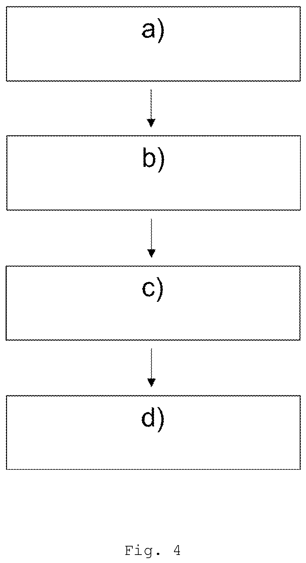

Fig. 4 zeigt eine schematische Darstellung eines Ausführungsbeispiels eines Verfahrens zur Herstellung einer elektrisch leitfähigen Beschichtung 100 eines elektrischen Bauelements 200 in einem Fließdiagramm. Gleiche und funktionsgleiche Elemente sind mit den gleichen Bezugszeichen versehen, so dass insofern auf die vorangegangene Beschreibung verwiesen wird.

Die elektrisch leitfähige Beschichtung 100 eines elektronischen Bauelements 200 kann mittels einer Reihe von Verfahren hergestellt werden. In einem Ausführungsbeispiel der Erfindung umfasst das Verfahren zum Beschichten des elektronischen Bauelements 200 mit der elektrisch leitfähigen Beschichtung 100 die folgenden Schritte:
a) Bereitstellen eines elektrischen Bauelements 200 mit mindestens einer Zelle mit mindestens einem strukturierten Schichtsystem 201, aufweisend eine Frontelektrode 202, eine Rückelektrode 203, und mindestens eine photoaktive Schicht 204, die zwischen der Frontelektrode 202 und der Rückelektrode 203 angeordnet ist, wobei die Rückelektrode 203 durch mindestens einen Graben 205 unterbrochen ist;
b) Auftragen mindestens eines Präkursors, eines Matrixmaterials und/oder eines Dotanden gleichzeitig oder als Mischung mittels eines Abscheideverfahrens oder eines Druckverfahrens zumindest auf die Rückelektrode 203 und in den mindestens einen Graben 205 der Rückelektrode 203, so dass zumindest die Rückelektrode 203 vollständig bedeckt wird; und c) Erhalten der Beschichtung 100.

Dadurch wird das elektrische Bauelement 200, insbesondere das Schichtsystem 201 des elektrischen Bauelements 200 vor Umwelteinflüssen und Beschädigung bei der Weiterverarbeitung oder bei der Benutzung geschützt. Das Verfahren zum Beschichten des elektronischen Bauelements 200 mit der elektrisch leitfähigen Beschichtung 100 kann insbesondere in einem Rolle-zu-Rolle-Verfahren eingesetzt werden.

Das strukturierte Schichtsystem 201 kann beispielsweise durch Laserstrukturierung jeweils nach dem Aufbringen der einzelnen Schichten, insbesondere der Schicht der Frontelektrode 202, der mindestens einen photoaktiven Schicht 204 und der Schicht der Rückelektrode 203 erhalten werden.

In einer weiteren Ausgestaltung der Erfindung wird nach Schritt c) in einem Schritt d) zumindest eine erste Sammelschiene 300 auf die Beschichtung 100 aufgebracht.

In einer weiteren Ausgestaltung der Erfindung wird das Verfahren in einem Rolle-zu-Rolle Verfahren durchgeführt, bevorzugt einem kontinuierlichen Rolle-zu-Rolle Verfahren.

In einem Ausführungsbeispiel wird die elektrisch leitfähige Beschichtung 100 vollständig auf die Rückelektrode 203 oder auf das gesamte elektrische Bauelement 200 aufgebracht. Dazu werden mittels eines PECVD-Verfahrens der Präkursor Hexamethyldisiloxan (HMDSO) in einem Gas-Volumen-Strom von 150 sccm, der Präkursor Tetra-isopropyl-Titan (TTIP) in einem Gas-Volumen-Strom von 1-15 sccm, und Sauerstoff in einem Gas-Volumen-Strom von 2000 sccm auf das elektrische Bauelement 200 aufgetragen. Als Trägergas wird Argon verwendet. Die Materialien werden abgeschieden, bis eine 800 nm dicke Schicht als Mischschicht vorliegt. Das elektrische Bauelement 200 wird beim Abscheiden der Materialien auf 5°C temperiert. Zur Bildung der Beschichtung 100 werden durch Plasmaanregung radikale/-ionisierte Spezies (z.B. O₂+, O, Si₂O(CH₃)₅) in-situ generiert. Im PECVD-Verfahren liegt die elektrische Plasmaleistung bei 10.5 kW und der Arbeitsdruck bei 5 Pa.

In einem weiteren Ausführungsbeispiel wird die Beschichtung 100 in einem PVD Verfahren unter Verwendung von zwei Materialien durch Auftragen mittels Verdampfung eines Isolators und eines TCO Matrixmaterials (ZnO, TiO₂, SnO₂) erhalten. Dabei wird ein isolierendes Material, z.B. SiO₂, mit einem TCO-Matrixmaterial, z.B. TiO₂, auf das elektrische Bauelement 200 co-verdampft.

In einem weiteren Ausführungsbeispiel wird die Beschichtung 100 in einem ALD-Verfahren mit einem Isolator und einem TCO Matrixmaterial (ZnO, TiO₂, SnO₂) erhalten.

## Patentansprüche

1. Elektrisches Bauelement (200) mit einer elektrisch leitfähigen Beschichtung (100) zur elektrisch leitfähigen Kontaktierung einer außerhalb der Beschichtung (100) angeordneten ersten Sammelschiene (300), das elektrische Bauelement (200) aufweisend mindestens eine Zelle mit mindestens einem strukturierten Schichtsystem (201), wobei das mindestens eine Schichtsystem (201) eine Frontelektrode (202), eine Rückelektrode (203), und mindestens eine photoaktive Schicht (204) aufweist, und die mindestens eine photoaktive Schicht (204) zwischen der Frontelektrode (202) und der Rückelektrode (203) angeordnet ist, und eine erste Sammelschiene (300), wobei die Beschichtung (100) auf der Rückseite des elektrischen Bauelements (200) über die vollständige Ausdehnung des elektrischen Bauelements (200) ausgebildet ist und zwischen dem mindestens einen Schichtsystem (201) und der ersten Sammelschiene (300) angeordnet ist, so dass zumindest die Rückelektrode (203) mit der ersten Sammelschiene (300) elektrisch leitfähig kontaktiert ist, wobei das mindestens eine Schichtsystem (201) derart strukturiert ist, dass die Rückelektrode (203) durch mindestens einen Graben (205) unterbrochen ist, und zumindest die Rückelektrode (203) der mindestens einen Zelle mit der Beschichtung (100) beschichtet und der mindestens eine Graben (205) der Rückelektrode (203) mit der Beschichtung (100) gefüllt ist, wobei die Beschichtung (100) einen spezifischen Widerstand von 0,01 bis 10000 Ωm aufweist, wobei ein Verhältnis des elektrischen Widerstands zwischen der Rückelektrode (203) und der ersten Sammelschiene (300) der Beschichtung (100) (R_{Schicht}) und dem elektrischen Widerstand über der Breite des Grabens (205) mit der Beschichtung (100) (R_{Graben}) mindestens 1:1000 beträgt.

2. Elektrisches Bauelement (200) nach Anspruch 1, wobei ein Verhältnis der Schichtdicke der Beschichtung (100) zu der Breite des mindestens einen Grabens (205) mindestens 1:10 beträgt, bevorzugt bevorzugt 1:10 bis 1:1000, und/oder eine Breite des mindestens einen Grabens (205) 1 µm bis 1 mm beträgt, und eine Schichtdicke der Beschichtung (100) 100 nm bis 100 µm beträgt.

3. Elektrisches Bauelement (200) nach Anspruch 1 oder 2, wobei ein Verhältnis einer Schichtdicke der Rückelektrode (203) zu einer Breite der ersten Sammelschiene (300) mindestens 1:10 beträgt, bevorzugt 1:10 bis 1:1000, und/oder die Breite der ersten Sammelschiene (300) 0,1 cm bis 10 cm beträgt, und die Schichtdicke der Rückelektrode (203) 10 nm bis 1 µm beträgt.

4. Elektrisches Bauelement (200) nach einem der vorhergehenden Ansprüche, wobei die Beschichtung (100) einen spezifischen Widerstand von 0,1 bis 1000 Ωm aufweist, und/oder das Verhältnis des elektrischen Widerstands zwischen der Rückelektrode (203) und der ersten Sammelschiene (300) der Beschichtung (100) (R_{Schicht}) und dem elektrischen Widerstand über der Breite des Grabens (205) mit der Beschichtung (100) (R_{Graben}) mindestens 1:5000 beträgt.

5. Elektrisches Bauelement (200) nach einem der vorhergehenden Ansprüche, wobei das mindestens eine Schichtsystem (201) derart strukturiert ist, dass die Strukturierung einen Graben (205) eines ersten Typs (P3), der die Rückelektrode (203) elektrisch leitfähig unterbricht, einen Graben (206) eines zweiten Typs (P1), der die Frontelektrode (202) elektrisch leitfähig unterbricht, und einen Graben (207) eines dritten Typs (P2), der die mindestens eine photoaktive Schicht (204) elektrisch leitfähig unterbricht, aufweist, so dass die Frontelektrode (202) und die Rückelektrode (203) der mindestens einen Zelle elektrisch leitfähig miteinander verschaltet sind.

6. Elektrisches Bauelement (200) nach einem der vorhergehenden Ansprüche, wobei die Beschichtung (100) auf der Vorderseite des elektrischen Bauelements (200) und der Rückseite des elektrischen Bauelements (200) über die vollständige Ausdehnung des elektrischen Bauelements (200) ausgebildet ist.

7. Elektrisches Bauelement (200) nach einem der vorhergehenden Ansprüche, wobei die Beschichtung (100) gebildet ist aus:
a) mindestens einem Präkursor ausgewählt aus der Gruppe bestehend aus Hexamethyldisiloxan (HMDSO), bis-Trimethylsilymethan (BTMSM), Tetraethylorthosilikat (TEOS), Hexamethyldisilazan (HMDSN), Silan (SiH₄), Triethoxysilan (TriEOS), Tetramethoxysilan (TMOS), Tetramethylsilan (TMS), und Trimethoxysilan (TriMOS), bis-Diethylamino-Silan (BTBAS), bevorzugt unter Verwendung eines Reaktionsgases ausgewählt aus Stickstoff oder Sauerstoff; oder
b) mindestens einem Matrixmaterial ausgewählt aus a), Siliciumoxycarbiden, bevorzugt SiOC oder SiOCH, oder einem SiOCH-ähnlichen Material, bevorzugt Siliciumcarboxynitriden (SiONCH), Siliciumcarbonitriden (SiNCH), Siliciumnitriden (SiN), Silicaten (SiO₂), und Al₂O₃; oder
c) mindestens einem Material ausgewählt aus b) und mindestens einem Dotanden, wobei der Dotand ausgewählt ist aus der Gruppe bestehend aus Diboran, Trimethyl-Bor, und Phosphin, oder einem TCO Material, bevorzugt ausgewählt aus der Gruppe bestehend aus Metall-Alkoxiden, Metall-Amiden, bevorzugt Titan-Alkoxid, insbesondere bevorzugt Titantetraisobutoxid, Titan-tetraisoethoxid, und Titan-tetraisomethoxid, Titan-tetra-isopropoxid (TTIP), TiCl₄, Dialkyl-Zink, bevorzugt Dimethyl-Zink oder Diethyl-Zink (DEZN), Zinnchlorid, Tetramethylzinn, Tetraethylzinn, ITO, In₂O₃, TiO₂, ZnO, und SnO₂.

8. Elektrisches Bauelement (200) nach einem der vorhergehenden Ansprüche, wobei das elektrische Bauelement (200) ein flexibles elektrisches Bauelement (200) ist, und/oder das elektrische Bauelement (200) ein photovoltaisches Element ist.

9. Verwendung einer elektrisch leitfähigen Beschichtung (100) als Schutzschicht eines elektrischen Bauelements (200) nach einem der Ansprüche 1 bis 8, insbesondere als Wickelschutz, und zur elektrisch leitfähigen Kontaktierung zumindest einer Rückelektrode (203) eines Schichtsystems (201) mit einer ersten Sammelschiene (300) des elektrischen Bauelements (200), wobei die Beschichtung (100) bevorzugt eine Elastizität von 80000 psi bis 360000 psi aufweist.

10. Verfahren zum Beschichten eines elektrischen Bauelements (200) nach einem der Ansprüche 1 bis 8, mit einer elektrisch leitfähigen Beschichtung (100), bevorzugt in einem Rolle-zu-Rolle Verfahren, umfassend die folgenden Schritte:
a) Bereitstellen eines elektrischen Bauelements (200) mit mindestens einer Zelle mit mindestens einem strukturierten Schichtsystem (201), aufweisend eine Frontelektrode (202), eine Rückelektrode (203), und mindestens eine photoaktive Schicht (204), die zwischen der Frontelektrode (202) und der Rückelektrode (203) angeordnet ist, wobei die Rückelektrode (203) durch mindestens einen Graben (205) unterbrochen ist;
b) Auftragen mindestens eines Präkursors, eines Matrixmaterials und/oder eines Dotanden gleichzeitig oder als Mischung mittels eines Abscheideverfahrens oder eines Druckverfahrens zumindest auf die Rückelektrode (203) und in den mindestens einen Graben (205) der Rückelektrode (203), so dass zumindest die Rückelektrode (203) vollständig bedeckt wird; und
c) Erhalten der Beschichtung (100).

## Claims

1. Electrical component (200) having an electrically conductive coating (100) for electrically conductively contacting a first busbar (300) arranged outside the coating (100), the electrical component (200) comprising at least one cell with at least one structured layer system (201), wherein the at least one layer system (201) has a front electrode (202), a back electrode (203), and at least one photoactive layer (204), and the at least one photoactive layer (204) is arranged between the front electrode (202) and the back electrode (203), and a first busbar (300), wherein the coating (100) is formed on the back side of the electrical component (200) over the complete extent of the electrical component (200) and is arranged between the at least one layer system (201) and the first busbar (300), such that at least the back electrode (203) is electrically conductively contacted with the first busbar (300), wherein the at least one layer system (201) is structured in such a way that the back electrode (203) is interrupted by at least one trench (205), and at least the back electrode (203) of the at least one cell is coated with the coating (100) and the at least one trench (205) of the back electrode (203) is filled with the coating (100), wherein the coating (100) has an electrical resistivity of 0.01 to 10000 Ωm, wherein a ratio of the electrical resistance between the back electrode (203) and the first busbar (300) of the coating (100) (R_{layer}) and the electrical resistance over the width of the trench (205) with the coating (100) (R_{trench}) is at least 1:1000.

2. Electrical component (200) according to Claim 1, wherein a ratio of the layer thickness of the coating (100) to the width of the at least one trench (205) is at least 1:10, particularly preferably 1:10 to 1:1000, and/or a width of the at least one trench (205) is 1 µm to 1 mm, and a layer thickness of the coating (100) is 100 nm to 100 µm.

3. Electrical component (200) according to Claim 1 or 2, wherein a ratio of a layer thickness of the back electrode (203) to a width of the first busbar (300) is at least 1:10, preferably 1:10 to 1:1000, and/or the width of the first busbar (300) is 0.1 cm to 10 cm, and the layer thickness of the back electrode (203) is 10 nm to 1 µm.

4. Electrical component (200) according to any of the preceding claims, wherein the coating (100) has an electrical resistivity of 0.1 to 1000 Ωm, and/or the ratio of the electrical resistance between the back electrode (203) and the first busbar (300) of the coating (100) (R_{layer}) and the electrical resistance over the width of the trench (205) with the coating (100) (R_{trench}) is at least 1:5000.

5. Electrical component (200) according to any of the preceding claims, wherein the at least one layer system (201) is structured in such a way that the structuring has a trench (205) of a first type (P3), which electrically conductively interrupts the back electrode (203), a trench (206) of a second type (P1), which electrically conductively interrupts the front electrode (202), and a trench (207) of a third type (P2), which electrically conductively interrupts the at least one photoactive layer (204), such that the front electrode (202) and the back electrode (203) of the at least one cell are electrically conductively interconnected with one another.

6. Electrical component (200) according to any of the preceding claims, wherein the coating (100) is formed on the front side of the electrical component (200) and the back side of the electrical component (200) over the complete extent of the electrical component (200).

7. Electrical component (200) according to any of the preceding claims, wherein the coating (100) is formed from:
a) at least one precursor selected from the group consisting of hexamethyldisiloxane (HMDSO), bis-trimethylsilylmethane (BTMSM), tetraethyl orthosilicate (TEOS), hexamethyldisilazane (HMDSN), silane (SiH₄), triethoxysilane (TriEOS), tetramethoxysilane (TMOS), tetramethylsilane (TMS), and trimethoxysilane (TriMOS), bis-diethylamino-silane (BTBAS), preferably using a reaction gas selected from nitrogen or oxygen; or
b) at least one matrix material selected from a), silicon oxycarbides, preferably SiOC or SiOCH, or an SiOCH-like material, preferably silicon carboxynitrides (SiONCH), silicon carbonitrides (SiNCH), silicon nitrides (SiN), silicates (SiO₂), and Al₂O₃; or
c) at least one material selected from b) and at least one dopant, wherein the dopant is selected from the group consisting of diborane, trimethyl boron, and phosphine, or a TCO material, preferably selected from the group consisting of metal alkoxides, metal amides, preferably titanium alkoxide, more particularly preferably titanium tetraisobutoxide, titanium tetraisoethoxide, and titanium tetraisomethoxide, titanium tetra-isopropoxide (TTIP), TiCl₄, dialkyl zinc, preferably dimethyl zinc or diethyl zinc (DEZN), tin chloride, tetramethyltin, tetraethyltin, ITO, In₂O₃, TiO₂, ZnO, and SnO₂.

8. Electrical component (200) according to any of the preceding claims, wherein the electrical component (200) is a flexible electrical component (200), and/or the electrical component (200) is a photovoltaic element.

9. Use of an electrically conductive coating (100) as a protective layer of an electrical component (200) according to any of Claims 1 to 8, in particular as winding protection, and for electrically conductively contacting at least one back electrode (203) of a layer system (201) with a first busbar (300) of the electrical component (200), wherein the coating (100) preferably has an elasticity of 80 000 psi to 360 000 psi.

10. Method for coating an electrical component (200) according to any of Claims 1 to 8, with an electrically conductive coating (100), preferably in a roll-to-roll method, comprising the following steps:
a) providing an electrical component (200) having at least one cell with at least one structured layer system (201), having a front electrode (202), a back electrode (203), and at least one photoactive layer (204) arranged between the front electrode (202) and the back electrode (203), wherein the back electrode (203) is interrupted by at least one trench (205);
b) applying at least one precursor, one matrix material and/or one dopant simultaneously or as a mixture by means of a deposition method or a printing method at least onto the back electrode (203) and into the at least one trench (205) of the back electrode (203), such that at least the back electrode (203) is completely covered; and
c) obtaining the coating (100).

## Revendications

1. Composant électrique (200) avec un revêtement électroconducteur (100) pour la mise en contact électriquement conductrice d'une première barre omnibus (300) disposée en dehors du revêtement (100), le composant électrique (200) présentant au moins une cellule pourvue d'un système de couches structuré (201), dans lequel ledit au moins un système de couches (201) présente une électrode avant (202), une électrode arrière (203) et au moins une couche photoactive (204), et ladite au moins une couche photoactive (204) est disposée entre l'électrode avant (202) et l'électrode arrière (203), et une première barre omnibus (300), dans lequel le revêtement (100) est réalisé sur la face arrière du composant électrique (200) sur toute l'étendue du composant électrique (200), et est disposé entre ledit au moins un système de couches (201) et la première barre omnibus (300) de sorte qu'au moins l'électrode arrière (203) est mise en contact de manière électriquement conductrice avec la première barre omnibus (300), dans lequel ledit au moins un système de couches (201) est structuré de telle sorte que l'électrode arrière (203) est interrompue par au moins une tranchée (205), et au moins l'électrode arrière (203) de ladite au moins une cellule est recouverte du revêtement (100), et ladite au moins une tranchée (205) de l'électrode arrière (203) est remplie avec le revêtement (100), dans lequel le revêtement (100) présente une résistance spécifique de 0,01 à 10000 Ωm , un rapport de la résistance électrique entre l'électrode arrière (203) et la première barre omnibus (300) du revêtement (100) (R_{Schicht}) et la résistance électrique sur la largeur de la tranchée (205) avec le revêtement (100) (R_{Graben}) est au moins 1:1000.

2. Composant électrique (200) selon la revendication 1, dans lequel un rapport de l'épaisseur de couche du revêtement (100) à la largeur de ladite au moins une tranchée (205) est au moins 1:10, de préférence de 1:10 à 1:1000, et/ou une largeur de ladite au moins une tranchée (205) est de 1 µm à 1 mm, et une épaisseur de couche du revêtement (100) est de 100 nm à 100 µm.

3. Composant électrique (200) selon la revendication 1 ou 2, dans lequel un rapport d'une épaisseur de couche de l'électrode arrière (203) à une largeur de la première barre omnibus (300) est au moins 1:10, de préférence de 1:10 à 1:1000, et/ou la largeur de la première barre omnibus (300) est de 0,1 cm à 10 cm, et l'épaisseur de couche de l'électrode arrière (203) est de 10 nm à 1 µm.

4. Composant électrique (200) selon l'une quelconque des revendications précédentes, dans lequel le revêtement (100) présente une résistance spécifique de 0,1 à 1000 Ωm, et/ou le rapport de la résistance électrique entre l'électrode arrière (203) et la première barre omnibus (300) du revêtement (100) (R_{Schicht}) et la résistance électrique sur la largeur de la tranchée (205) avec le revêtement (100) (R_{Graben}) est au moins 1:5000.

5. Composant électrique (200) selon l'une quelconque des revendications précédentes, dans lequel ledit au moins un système de couches (201) est structuré de telle sorte que la structuration interrompt une tranchée (205) d'un premier type (P3) qui interrompt l'électrode arrière (203) de manière électriquement conductrice, une tranchée (206) d'un deuxième type (P1) qui interrompt l'électrode avant (202) de manière électriquement conductrice, et une tranchée (207) d'un troisième type (P2) qui présente ladite au moins une couche photoactive (204) de manière électriquement conductrice de sorte que l'électrode avant (202) et l'électrode arrière (203) de ladite au moins une cellule sont interconnectées de manière électriquement conductrice.

6. Composant électrique (200) selon l'une quelconque des revendications précédentes, dans lequel le revêtement (100) est réalisé sur la face avant du composant électrique (200) et la face arrière du composant électrique (200) sur toute l'étendue du composant électrique (200).

7. Composant électrique (200) selon l'une quelconque des revendications précédentes, dans lequel le revêtement (100) est formé à partir :
a) d'au moins un précurseur sélectionné dans le groupe composé d'hexaméthyldisiloxane (HMDSO), de bis-triméthylsilyméthane (BTMSM), d'orthosilicate de tétraéthyle (TEOS), d'hexaméthyldisilazane (HMDSN), de silane (SiH₄), de triéthoxysilane (TriEOS), de tétraméthoxysilane (TMOS), de tétraméthylsilane (TMS), et de triméthoxysilane (TriMOS), de bis-diéthylaminosilane (BTBAS), de préférence en utilisant un gaz de réaction sélectionné parmi l'azote ou l'oxygéné ; ou
b) d'au moins un matériau de matrice sélectionné parmi a) les oxycarbures de silicium, de préférence le SiOC ou le SiOCH, ou un matériau similaire au SiOCH, de préférence des carboxynitrures de silicium (SiONCH), des carbonitrures de silicium (SiNCH), des nitrures de silicium (SiN), des silicates (SiO₂) et d'Al₂O₃ ; ou
c) d'au moins un matériau sélectionné parmi b) et au moins un agent dopant, l'agent dopant étant sélectionné dans le groupe composé de diborane, de borate de triméthyle et de phosphine, ou d'un matériau TCO, de préférence sélectionné dans le groupe composé d'alkoxydes métalliques, d'amides métalliques, de préférence d'alkoxyde de titane, de manière particulièrement préférée de tétraisobutoxyde de titane, de tétraisoéthoxyde de titane et de tétraisométhoxyde de titane, de tétraisopropoxyde de titane (TTIP), de TiCl₄, de dialkylzinc, de préférence de diméthylzinc ou de diéthylzinc (DEZN), de chlorure de zinc, de tétraméthylétain, de tétraéthylétain, d'ITO, d'In₂O₃, de TiO₂, de ZnO et de SnO₂.

8. Composant électrique (200) selon l'une quelconque des revendications précédentes, dans lequel le composant électrique (200) est un composant électrique (200) souple et/ou le composant électrique (200) est un élément photovoltaïque.

9. Utilisation d'un revêtement (100) électroconducteur comme couche de protection d'un composant électrique (200) selon l'une quelconque des revendications 1 à 8, en particulier comme protection anti-enroulement, et pour la mise en contact électriquement conductrice d'au moins une électrode arrière (203) d'un système de couches (201) avec une première barre omnibus (300) du composant électrique (200), le revêtement (100) présentant de préférence une élasticité de 80000 psi à 360000 psi.

10. Procédé permettant de couvrir un composant électrique (200) selon l'une quelconque des revendications 1 à 8, comprenant un revêtement électroconducteur (100), de préférence dans un procédé de rouleau à rouleau, comprenant les étapes suivantes consistant à :
a) prévoir un composant électrique (200) pourvu d'au moins une cellule avec au moins un système de couches structuré (201), présentant une électrode avant (202), une électrode arrière (203) et au moins une couche photoactive (204) qui est disposée entre l'électrode avant (202) et l'électrode arrière (203), l'électrode arrière (203) étant interrompue par au moins une tranchée (205) ;
b) appliquer au moins un précurseur, un matériau de matrice et/ou un agent dopant en même temps ou sous forme de mélange au moyen d'un procédé de dépôt ou d'un procédé d'impression au moins sur l'électrode arrière (203) et dans ladite au moins une tranchée (205) de l'électrode arrière (203) de sorte qu'au moins l'électrode arrière (203) est entièrement couverte ; et
c) obtenir le revêtement (100).
